# EUROPEAN PATENT APPLICATION

(11) **EP 4 401 537 A1**
(43) Date of publication of application: **17.07.2024**
(21) Application number: 22867420.6
(22) Date of filing: 09.09.2022
(51) Int. Cl.: H10N 15/00

(54) **METHOD FOR MANUFACTURING POWER GENERATION ELEMENT, POWER GENERATION ELEMENT, POWER GENERATION DEVICE, AND ELECTRONIC APPARATUS**

(30) Priority: 10.09.2021 JP 2021147809
(71) Applicant: GCE Institute Inc., Tokyo 104-0061 (JP)
(72) Inventor: GOTO, Hiroshi, Tokyo 104-0061 (JP); SAKATA, Minoru, Tokyo 104-0061 (JP); YASUDA, Takuo, Tokyo 104-0061 (JP); ANDERSSON, Lars Mattias, Tokyo 104-0061 (JP); OKADA, Seiji, Tokyo 104-0061 (JP); NAKAMURA, Takahiro, Tokyo 104-0061 (JP)
(74) Representative: Novagraaf International SA
(86) International application number: PCT/JP2022/033827
(87) International publication number: WO 2023/038099

(57) **Abstract**

[Object]

To provide a method for manufacturing a power generation element, a power generation element, a power generation device, and an electronic apparatus that are capable of stabilizing a power generation amount.

[Solution]

A method for manufacturing a power generation element that does not require a temperature difference between electrodes in converting thermal energy into electric energy includes a first electrode forming process of forming a first electrode 11, an intermediate portion forming process of forming, on the first electrode 11, an intermediate portion 14 including an insulating layer being in a solid state, and a second electrode forming process of forming a second electrode 12 having a work function different from a work function of the first electrode 11 on the insulating layer, wherein the intermediate portion 14 includes nanoparticles fixed in a dispersed state in the insulating layer.

## Description

### Technical Field

The present invention relates to a method for manufacturing a power generation element that does not require a temperature difference between electrodes in converting thermal energy into electric energy, a power generation element, a power generation device, and an electronic apparatus.

### Background Art

In recent years, power generation elements that generate electric energy by utilizing thermal energy have been actively developed. In particular, regarding a power generation element that does not require a temperature difference between electrodes, for example, a power generation element disclosed in Patent Literature 1 or the like has been proposed. Such a power generation element is expected to be used in various applications as compared with a configuration in which electric energy is generated by using a temperature difference applied between electrodes.

Patent Literature 1 discloses a method for manufacturing a power generation element including a generating process of generating nanoparticles dispersed in a solvent or an organic solvent by using a femtosecond pulse laser, a first electrode portion forming process of forming a first electrode portion on a first substrate, a second electrode portion forming process of forming a second electrode portion on a second substrate, and a bonding process of bonding the first substrate and the second substrate with the solvent or the organic solvent interposed between the first electrode portion and the second electrode portion.

### Citation List

### Patent Literature

Patent Literature 1: JP 6781437 B

### Summary of Invention

### Technical Problem

Here, when the solvent in which the nanoparticles are dispersed is provided between the electrodes as in the power generation element disclosed in Patent Literature 1, the nanoparticles may be unevenly distributed to one electrode side over time. For this reason, there is a concern that a movement amount of electrons between the electrodes decreases and a stable power generation amount cannot be obtained.

The present invention has been made in consideration of the above problem, and an object of the present invention is to provide a method for manufacturing a power generation element, a power generation element, a power generation device, and an electronic apparatus that are capable of stabilizing a power generation amount.

### Solution to Problem

A method for manufacturing a power generation element according to a first aspect of the present invention is a method for manufacturing a power generation element that does not require a temperature difference between electrodes in converting thermal energy into electric energy, the method including a first electrode forming process of forming a first electrode, an intermediate portion forming process of forming, on the first electrode, an intermediate portion including an insulating layer being in a solid state, and a second electrode forming process of forming a second electrode having a work function different from a work function of the first electrode, wherein the intermediate portion includes nanoparticles fixed in a dispersed state in the insulating layer.

A method for manufacturing a power generation element according to a second aspect of the present invention is the method according to the first aspect of the present invention, the method further including, after the second electrode forming process, a sealing material forming process of forming a sealing material being in contact with the first electrode, the intermediate portion, and the second electrode.

A method for manufacturing a power generation element according to a third aspect of the present invention is the method for manufacturing the power generation element according to the first aspect of the present invention, wherein the second electrode forming process forms the second electrode on a surface of the insulating layer under a reduced pressure environment, and the work function of the first electrode is higher than the work function of the second electrode.

A method for manufacturing a power generation element according to a fourth aspect of the present invention is the method for manufacturing the power generation element according to the first aspect of the present invention, wherein the second electrode forming process includes bringing a surface of the second electrode provided on a substrate in advance into contact with a surface of the insulating layer.

A method for manufacturing a power generation element according to a fifth aspect of the present invention is the method for manufacturing the power generation element according to the first aspect of the present invention, wherein the insulating layer includes an organic polymer compound.

A power generation element according to a sixth aspect of the present invention is a power generation element that does not require a temperature difference between electrodes in converting thermal energy into electric energy, the power generation element including a first electrode, an intermediate portion provided on the first electrode, the intermediate portion including an insulating layer being in a solid state, and a second electrode provided on the insulating layer, the second electrode having a work function different from a work function of the first electrode, wherein the intermediate portion includes nanoparticles fixed in a dispersed state in the insulating layer.

A power generation element according to a seventh aspect of the present invention is the power generation element according to the sixth aspect of the present invention, wherein the nanoparticles include a metal oxide other than magnetic substances.

A power generation device according to an eighth aspect of the present invention is a power generation device including the power generation element according to the sixth aspect of the present invention, a first wiring line electrically connected to the first electrode, and a second wiring line electrically connected to the second electrode.

An electronic apparatus according to a ninth aspect of the present invention is an electronic apparatus including the power generation element according to the sixth aspect of the present invention, and an electronic component configured to be driven by using the power generation element as a power source.

### Advantageous Effects of Invention

According to the first aspect to the fifth aspect of the present invention, the intermediate portion forming process forms the intermediate portion including the insulating layer being in the solid state on the first electrode, and the intermediate portion includes the nanoparticles fixed in the dispersed state in the insulating layer. That is, movement of nanoparticles between the electrodes is suppressed. For this reason, uneven distribution of the nanoparticles on one electrode side over time and a decrease in movement amount of electrons can be suppressed. This makes it possible to stabilize a power generation amount.

Further, according to the first aspect to the fifth aspect of the present invention, the intermediate portion forming process forms the intermediate portion including the insulating layer being in the solid state on the first electrode. Additionally, the second electrode forming process forms, on the insulating layer, the second electrode having the work function different from the work function of the first electrode. Thus, as compared with a case where a solvent or the like is used instead of the insulating layer, a support portion or the like for maintaining a distance (gap) between the electrodes does not need to be provided, and a variation in the gap caused by formation accuracy of the support portion can be eliminated. This makes it possible to increase the power generation amount.

In particular, according to the second aspect of the present invention, the sealing material forming process forms the sealing material being in contact with the first electrode, the intermediate portion, and the second electrode, after the second electrode forming process. Thus, deterioration of the insulating layer and the nanoparticles caused by an external environment can be suppressed. This can improve durability.

In particular, according to the third aspect of the present invention, the second electrode forming process forms the second electrode on the surface of the insulating layer under the reduced pressure environment. This can suppress a variation in the work function of the second electrode. This makes it possible to further stabilize the power generation amount.

In particular, according to the fourth aspect of the present invention, the second electrode forming process includes bringing the surface of the second electrode provided on the substrate in advance into contact with the surface of the insulating layer. Thus, as compared with a case where the second electrode is directly formed on the surface of the insulating layer, a variation in surface state of the second electrode caused by a surface state of the insulating layer can be suppressed. This makes it possible to improve the power generation amount.

In particular, according to the fifth aspect of the present invention, the insulating layer includes the organic polymer compound. Thus, the insulating layer can be flexibly formed. This makes it possible to form the power generation element having a shape suitable for its application.

According to the sixth aspect and the seventh aspect of the present invention, the intermediate portion is provided on the first electrode and includes the insulating layer being in the solid state and the nanoparticles fixed in the dispersed state in the insulating layer. That is, movement of the nanoparticles between the electrodes is suppressed. For this reason, uneven distribution of the nanoparticles on one electrode side over time and a decrease in movement amount of electrons can be suppressed. This makes it possible to stabilize the power generation amount.

Further, according to the sixth aspect and the seventh aspect of the present invention, the intermediate portion is provided on the first electrode and includes the insulating layer being in the solid state. Furthermore, the second electrode is provided on the insulating layer and has the work function different from the work function of the first electrode. Thus, as compared with a case where a solvent or the like is used instead of the insulating layer, a support portion or the like for maintaining a distance (gap) between the electrodes does not need to be provided, and a variation in the gap caused by formation accuracy of the support portion can be eliminated. This makes it possible to improve the power generation amount.

In particular, according to the seventh aspect of the present invention, the nanoparticles include a metal oxide other than the magnetic substances. Thus, a decrease in power generation amount over time can be suppressed without being influenced by a magnetic field caused by an external environment.

In particular, according to the eighth aspect of the present invention, the power generation device includes the power generation element according to the sixth aspect of the present invention. This makes it possible to implement the power generation device that stabilizes the power generation amount.

In particular, according to the ninth aspect of the present invention, the electronic apparatus includes the power generation element according to the sixth aspect of the present invention. This makes it is possible to implement the electronic apparatus that stabilizes the power generation amount.

### Brief Description of Drawings

FIG. 1(a) is a schematic cross-sectional view illustrating an example of a power generation element and a power generation device according to a first embodiment, and FIG. 1(b) is a schematic cross-sectional view taken along a line A-A in FIG. 1(a).
FIG. 2 is a schematic cross-sectional view illustrating an example of an intermediate portion.
FIG. 3 is a flowchart illustrating an example of a method for manufacturing the power generation element according to the first embodiment.
FIG. 4(a) to FIG. 4(d) are schematic cross-sectional views illustrating an example of the method for manufacturing the power generation element according to the first embodiment.
FIG. 5(a) is a schematic cross-sectional view illustrating a first modification of the power generation element and the power generation device according to the first embodiment, and FIG. 5(b) is a schematic cross-sectional view illustrating a second modification of the power generation element and the power generation device according to the first embodiment.
FIG. 6(a) to FIG. 6(d) are schematic block diagrams illustrating an example of an electronic apparatus including the power generation element, and FIG. 6(e) to FIG. 6(h) are schematic block diagrams illustrating an example of an electronic apparatus including the power generation device including the power generation element.

### Description of Embodiments

Hereinafter, examples of a method for manufacturing a power generation element, a power generation element, a power generation device, and an electronic apparatus as embodiments of the present invention will be described with reference to the drawings. Note that in each drawing, a height direction in which electrodes are laminated is referred to as a first direction Z, one planar direction intersecting, for example, orthogonal to, the first direction Z is referred to as a second direction X, and another planar direction intersecting, for example, orthogonal to, both of the first direction Z and the second direction X is referred to as a third direction Y. In addition, a configuration in each drawing is schematically illustrated for description, and for example, a size of each configuration, a ratio of sizes between configurations, or the like may be different from that in the drawing.

### Embodiment: Power Generation Element 1, Power Generation Device 100

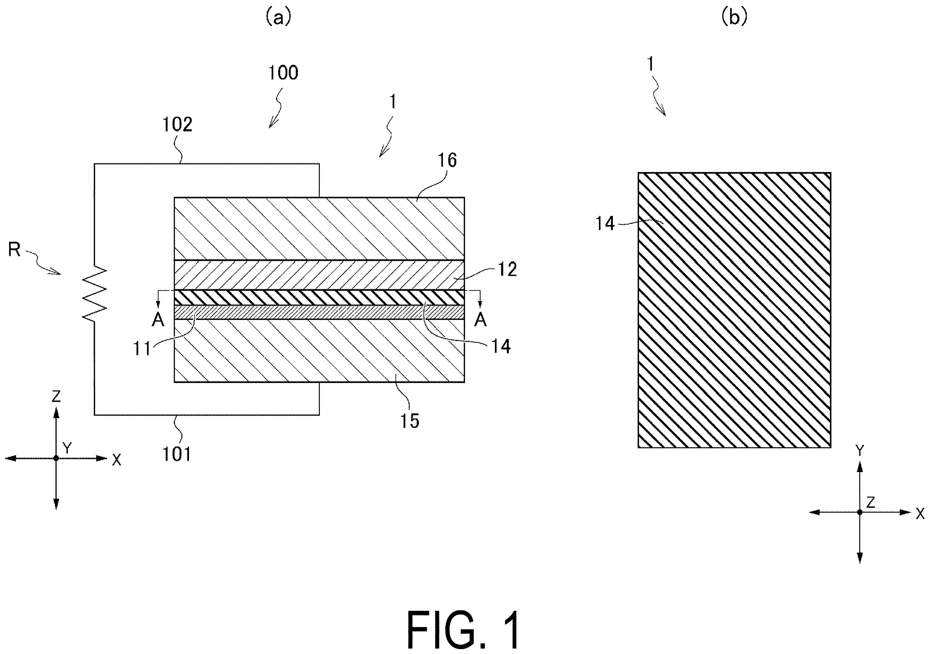

FIG. 1 is a schematic view illustrating an example of a power generation element 1 and a power generation device 100 according to the present embodiment. FIG. 1(a) is a schematic cross-sectional view illustrating an example of the power generation element 1 and the power generation device 100 according to the present embodiment, and FIG. 1(b) is a schematic cross-sectional view taken along a line A-A in FIG. 1(a).

### Power Generation Device 100

As illustrated in FIG. 1(a), the power generation device 100 includes the power generation element 1, a first wiring line 101, and a second wiring line 102. The power generation element 1 converts thermal energy into electric energy. The power generation device 100 including such a power generation element 1 is mounted or installed at a heat source (not illustrated), for example, and outputs electric energy generated from the power generation element 1 to a load R through the first wiring line 101 and the second wiring line 102 based on thermal energy of the heat source. One end of the load R is electrically connected to the first wiring line 101, and the other end is electrically connected to the second wiring line 102. The load R is, for example, an electrical device. The load R is driven by using, for example, the power generation device 100 as a main power source or an auxiliary power source.

Examples of a heat source of the power generation element 1 include an electronic device or an electronic component such as a central processing unit (CPU), a light emitting element such as a light emitting diode (LED), an engine of an automobile or the like, production equipment of a factory, a human body, sunlight, and an environmental temperature. For example, the electronic device, electronic component, light emitting element, engine, and production equipment, and the like are artificial heat sources. The human body, sunlight, and environmental temperature, and the like are natural heat sources. The power generation device 100 including the power generation element 1 can be provided inside a mobile device such as an Internet of Things (IoT) device and a wearable device or an autonomous sensor terminal, and can be used as an alternative or an auxiliary of a battery. Further, the power generation device 100 can be applied to a larger power generation device for photovoltaic power generation or the like.

### Power Generation Element 1

The power generation element 1 converts, for example, thermal energy generated by the artificial heat source or thermal energy of the natural heat source into electric energy to generate an electric current. Not only can the power generation element 1 be provided in the power generation device 100 but also the power generation element 1 itself can be provided in the mobile device, the autonomous sensor terminal, or the like. In this case, the power generation element 1 itself can serve as an alternative component or an auxiliary component of the battery for the mobile device, the autonomous sensor terminal, or the like.

For example, as illustrated in FIG. 1(a), the power generation element 1 includes a first electrode 11, a second electrode 12, and an intermediate portion 14. The power generation element 1 may include, for example, at least one of a first substrate 15 and a second substrate 16.

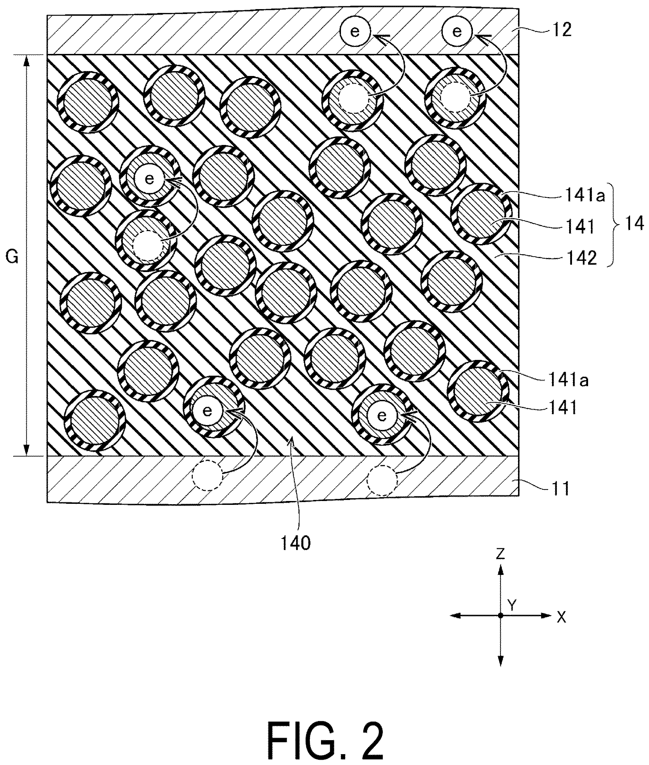

The first electrode 11 and the second electrode 12 are provided so as to face each other. The first electrode 11 and the second electrode 12 have different work functions from each other. For example, as illustrated in FIG. 2, the intermediate portion 14 is provided in a space 140 including a gap (gap G) between the first electrode 11 and the second electrode 12.

The intermediate portion 14 includes nanoparticles 141 and an insulating layer 142 being in a solid state. The nanoparticles 141 are fixed in a dispersed state in the insulating layer 142. In this case, movement of the nanoparticles 141 in the gap G is suppressed. For this reason, uneven distribution of the nanoparticles 141 to one of the electrodes 11 and 12 over time and a decrease in movement amount of electrons can be suppressed. This makes it possible to stabilize the power generation amount.

The intermediate portion 14 is provided on the first electrode 11. Moreover, the second electrode 12 is provided on the insulating layer 142. Here, in the power generation element 1 that does not require the temperature difference between the electrodes in converting thermal energy into electric energy, suppressing a variation in the gap G in a surface along the second direction X and the third direction Y can cause the power generation amount to be increased. In this regard, when a liquid such as a solvent is used as the intermediate portion, a support portion or the like for maintaining the gap G needs to be provided. However, there has been a concern that the variation in the gap G may be increased due to the formation of the support portion or the like. In contrast, in the power generation element 1 according to the present embodiment, since the second electrode 12 is provided on the insulating layer 142, the support portion or the like for maintaining the gap G does not need to be provided, and the variation in the gap caused by formation accuracy of the support portion or the like can be eliminated. This makes it possible to increase the power generation amount.

In addition, when the support portion or the like for maintaining the gap is provided, there is a concern that the nanoparticles 141 will come into contact with the support portion and aggregate around the support portion. On the other hand, in the power generation element 1 according to the present embodiment, the aggregation of the nanoparticles 141 caused by the support portion can be eliminated. This makes it possible to maintain the stable power generation amount.

Hereinafter, each configuration will be described in detail.

### First Electrode 11 and Second Electrode 12

For example, as illustrated in FIG. 1(a), the first electrode 11 and the second electrode 12 are separated from each other in the first direction Z. Each of the electrodes 11 and 12 extends in, for example, the second direction X and the third direction Y, and a plurality of electrodes 11 and/or 12 may be provided. For example, one second electrode 12 may be provided so as to face a plurality of first electrodes 11 at different positions. In addition, for example, one first electrode 11 may be provided to face a plurality of second electrodes 12 at different positions.

As a material of each of the first electrode 11 and the second electrode 12, a material having electrical conductivity is used. For example, materials having different work functions from each other are used as the materials of the first electrode 11 and the second electrode 12. Note that the same material may be used for the electrodes 11 and 12, and in this case, it is sufficient that the electrodes 11 and 12 have different work functions from each other.

As the material of each of the electrodes 11 and 12, for example, a material made of a single element such as iron, aluminum, or copper may be used, or for example, an alloy material made of two types or more of elements may be used. For example, a non-metal conductive material may be used as the material of each of the electrodes 11 and 12. Examples of the non-metal conductive material include silicon (Si: for example, p-type Si or n-type Si) and a carbon-based material such as graphene.

Thicknesses of the first electrode 11 and the second electrode 12 in the first direction Z are equal to or more than 4 nm and equal to or less than 1 µm, for example. The thicknesses of the first electrode 11 and the second electrode 12 in the first direction Z may be, for example, equal to or more than 4 nm and equal to or less than 50 nm.

The gap G indicating the distance between the first electrode 11 and the second electrode 12 can be set in a freely selected manner, by changing a thickness of the insulating layer 142. For example, narrowing the gap G can cause the electric field generated between the electrodes 11 and 12 to be enlarged, and thus the power generation amount of the power generation element 1 can be increased. In addition, for example, narrowing the gap G can cause a thickness of the power generation element 1 in the first direction Z to be reduced.

The gap G is, for example, a finite value equal to or less than 500 µm. The gap G is, for example, equal to or more than 10 nm and equal to or less than 1 µm. For example, when the gap G is equal to or smaller than 200 nm, a variation in the gap G of a surface along the second direction X and the third direction Y may lead to a decrease in the power generation amount. Additionally, when the gap G is larger than 1 µm, the electric field generated between the electrodes 11 and 12 may be weakened. Thus, the gap G is preferably larger than 200 nm and equal to or smaller than 1 µm.

### Intermediate Portion 14

For example, as illustrated in FIG. 1(b), the intermediate portion 14 extends in a plane along the second direction X and the third direction Y. The intermediate portion 14 is provided in the space 140 formed between the electrodes 11 and 12. The intermediate portion 14 may be in contact with main surfaces of the electrodes 11 and 12 that face each other, or may be in contact with side surfaces of the electrodes 11 and 12, for example.

The nanoparticles 141 are dispersed in the insulating layer 142, and for example, some of the nanoparticles 141 may be exposed from the insulating layer 142. A particle diameter of the nanoparticle 141 is smaller than a size of the gap G, for example. The particle diameter of the nanoparticle 141 is set to a finite value equal to or less than 1/10 of the size of the gap G, for example. When the particle diameter of the nanoparticle 141 is set to be equal to or less than 1/10 of the size of the gap G, the intermediate portion 14 including the nanoparticles 141 is easily formed in the space 140. As a result, workability can be improved when the power generation element 1 is produced.

Here, the "nanoparticle" includes a plurality of particles. The nanoparticle 141 includes particles each of which has a particle diameter equal to or more than 2 nm and equal to or less than 100 nm, for example. The nanoparticle 141 may include, for example, particles having particle diameters whose median diameter (D50) is equal to or more than 3 nm and equal to or less than 8 nm, or particles having particle diameters whose average particle diameter is equal to or more than 3 nm and equal to or less than 8 nm. The median diameter or the average particle diameter can be measured by using, for example, a particle size distribution measuring instrument. As the particle size distribution measuring instrument, for example, a particle size distribution measuring instrument using a dynamic light scattering method (for example, Zetasizer Ultra manufactured by Malvern Panalytical Ltd. or the like) may be used.

The nanoparticle 141 includes, for example, a conductive material, and a freely selected material is used depending on the application. The nanoparticle 141 may include, for example, one type of material, or may include a plurality of materials depending on the application. A value of the work function of the nanoparticle 141 may be between a value of the work function of the first electrode 11 and a value of the work function of the second electrode 12, for example, or may be other than between the value of the work function of the first electrode 11 and the value of the work function of the second electrode 12, for example, and is freely selected.

The nanoparticle 141 includes, for example, a metal. As the nanoparticle 141, for example, a particle containing one type of material such as gold or silver, or a particle of an alloy containing two or more types of materials may be used.

The nanoparticle 141 includes, for example, a metal oxide. As the nanoparticle 141 containing a metal oxide, a metal oxide of at least one element selected from the group consisting of metals and Si, such as zirconia (ZrO₂), titania (TiO₂), silica (SiO₂), alumina (Al₂O₃), iron oxide (Fe₂O₃, Fe₂O₅), copper oxide (CuO), zinc oxide (ZnO), yttria (Y₂O₃), niobium oxide (Nb₂O₅), molybdenum oxide (MoOs), indium oxide (In₂O₃), tin oxide (SnO₂), tantalum oxide (Ta₂O₅), tungsten oxide (WO₃), lead oxide (PbO), bismuth oxide (Bi₂O₃), ceria (CeO₂), or antimony oxide (Sb₂O₅, Sb₂O₃), is used. The nanoparticle 141 may include, for example, a dielectric.

The nanoparticle 141 may include, for example, a metal oxide other than magnetic substances. For example, when the nanoparticle 141 includes a metal oxide exhibiting magnetism, the movement of the nanoparticles 141 may be limited by a magnetic field generated due to an environment in which the power generation element 1 is installed. Thus, by including the metal oxide other than the magnetic substances, the nanoparticles 141 are not influenced by the magnetic field caused by the external environment, and a decrease in power generation amount over time can be suppressed.

The nanoparticle 141 includes, for example, a coating 141a on the surface thereof. The coating 141a has a thickness of, for example, a finite value equal to or less than 20 nm. Providing such a coating 141a on the surface of each nanoparticle 141 allows aggregation of the nanoparticles 141 when the nanoparticles 141 are dispersed in the insulating layer 142 to be suppressed. In addition, for example, it is possible to increase a probability that electrons will move between the first electrode 11 and the fine particle 141, between the plurality of nanoparticles 141, and between the second electrode 12 and the nanoparticle 141, by using a tunneling effect or the like.

As the coating 141a, for example, a material including a thiol group or a disulfide group is used. As the material including the thiol group, for example, alkanethiol such as dodecanethiol is used. As the material including the disulfide group, for example, alkane disulfide or the like is used.

The insulating layer 142 is provided between the electrodes 11 and 12, and is in contact with the respective electrodes 11 and 12, for example. The insulating layer 142 has a thickness of a finite value equal to or less than 500 µm, for example. The thickness of the insulating layer 142 affects the value and variation of the gap G described above. Thus, for example, when the thickness of the insulating layer 142 is equal to or less than 200 nm, the variation in the gap G in the surface along the second direction X and the third direction Y may lead to a decrease in the power generation amount. In addition, when the thickness of the insulating layer 142 is larger than 1 µm, the electric field generated between the electrodes 11 and 12 may be weakened. For these reasons, the thickness of the insulating layer 142 is preferably equal to or more than 200 nm and equal to or less than 1 µm.

The insulating layer 142 may include, for example, one type of material, or may include a plurality of materials depending on the application. The insulating layer 142 may include, for example, a plurality of layers including different materials, and may include a configuration in which the layers are laminated. When the insulating layer 142 includes a plurality of layers, for example, the layers may contain the nanoparticles 141 including different materials from each other in a dispersed manner.

The insulating layer 142 has, for example, an insulating property. A material to be used for the insulating layer 142 is freely selected as long as the material is an insulating material capable of fixing the nanoparticles 141 in a dispersed state, but an organic polymer compound is preferably used. When the insulating layer 142 includes the organic polymer compound, the insulating layer 142 can be formed so as to be flexible, and thus the power generation element 1 having a shape such as a curved shape or a bent shape according to the application can be formed.

As the organic polymer compound, polyimide, polyamide, polyester, polycarbonate, poly (meth) acrylate, a radical polymerization system of photosetting resin or thermosetting resin, a photocationic polymerization system of photosetting resin or thermosetting resin, an epoxy resin, a copolymer containing an acrylonitrile component, polyvinylphenol, polyvinylalcohol, polystyrene, a novolac resin, polyvinylidene fluoride, or the like can be used.

Note that, for example, an inorganic substance may be used as the insulating layer 142. Examples of the inorganic substance include porous inorganic substances such as zeolite and diatomaceous earth, and cage-like molecules.

### First Substrate 15 and Second Substrate 16

For example, as illustrated in FIG. 1(a), the first substrate 15 and the second substrate 16 are provided to sandwich the electrodes 11 and 12 and the intermediate portion 14 and to be separated from each other in the first direction Z. For example, the first substrate 15 is in contact with the first electrode 11 and is separated from the second electrode 12. The first substrate 15 fixes the first electrode 11. The second substrate 16 is in contact with the second electrode 12 and is separated from the first electrode 11. The second substrate 16 fixes the second electrode 12.

Thicknesses of the substrates 15 and 16 in the first direction Z are, for example, equal to or more than 10 µm and equal to or less than 2 mm. The thicknesses of the substrates 15 and 16 can be freely selected and set. A shape of each of the substrates 15 and 16 may be, for example, a quadrangular shape such as a square or a rectangle, a disk shape, or the like, and can be freely selected and set according to the application.

As each of the substrates 15 and 16, for example, a plate-shaped member having an insulating property can be used, and for example, a known member made of a material such as silicon, quartz, or Pyrex (registered trademark) can be used. For each of the substrates 15 and 16, for example, a film-like member may be used, and for example, a known film-like member made of a material such as polyethylene terephthalate (PET), polycarbonate (PC), or polyimide may be used.

As each of the substrates 15 and 16, for example, a member having electrical conductivity can be used, and examples thereof include iron, aluminum, copper, and an alloy of aluminum and copper. In addition, as the substrates 15 and 16, a member made of a material such as an electrically conductive semiconductor such as Si or GaN, or a conductive polymer may be used. When the member having the electrical conductivity is used for each of the substrates 15 and 16, wiring lines for connection to the electrodes 11 and 12 are not required.

For example, when the first substrate 15 is a semiconductor, the first substrate 15 may include a degenerate portion being in contact with the first electrode 11. In this case, a contact resistance between the first electrode 11 and the first substrate 15 can be reduced, compared to a case where the degenerate portion is not provided. The first substrate 15 may include the degenerate portion on a surface different from the surface being in contact with the first electrode 11. In this case, the contact resistance with a wiring line (for example, the first wiring line 101) electrically connected to the first substrate 15 can be reduced.

For example, when a plurality of power generation elements 1 illustrated in FIG. 1(a) are laminated, a semiconductor may be used as the first substrate 15 and the second substrate 16. In this case, the contact resistance can be reduced by providing the degenerate portion on the contact surface between the substrates 15 and 16 that come into contact with each other along with laminating the power generation elements 1.

The above-described degenerate portion is formed, for example, by ion-implanting an n-type dopant into the semiconductor at a high concentration or by coating the semiconductor with a material such as glass containing an n-type dopant and performing heat treatment after the coating.

Note that examples of an impurity to be doped into the first substrate 15 made of the semiconductor include known impurities such as P, As, and Sb in the case of n-type impurities, and known impurities such as B, Ba, and Al in the case of p-type impurities. Additionally, when the concentration of the impurity in the degenerate portion is, for example, 1 × 10¹⁹ ions/cm³, electrons can be efficiently emitted.

For example, when the first substrate 15 is a semiconductor, a specific resistance value of the first substrate 15 may be, for example, equal to or more than 1 × 10⁻⁶ Ω·cm and equal to or less than 1 × 10⁶ Ω·cm. When the specific resistance value of the first substrate 15 is less than 1 × 10⁻⁶ Ω·cm, selection of the material is difficult. In addition, when the specific resistance value of the first substrate 15 is larger than 1 × 10⁶ Ω·cm, there is a concern that an electric current loss increases.

It should be noted that although the case where the first substrate 15 is the semiconductor has been described above, the second substrate 16 may be a semiconductor. Since this case is similar to the case described above, description will be omitted.

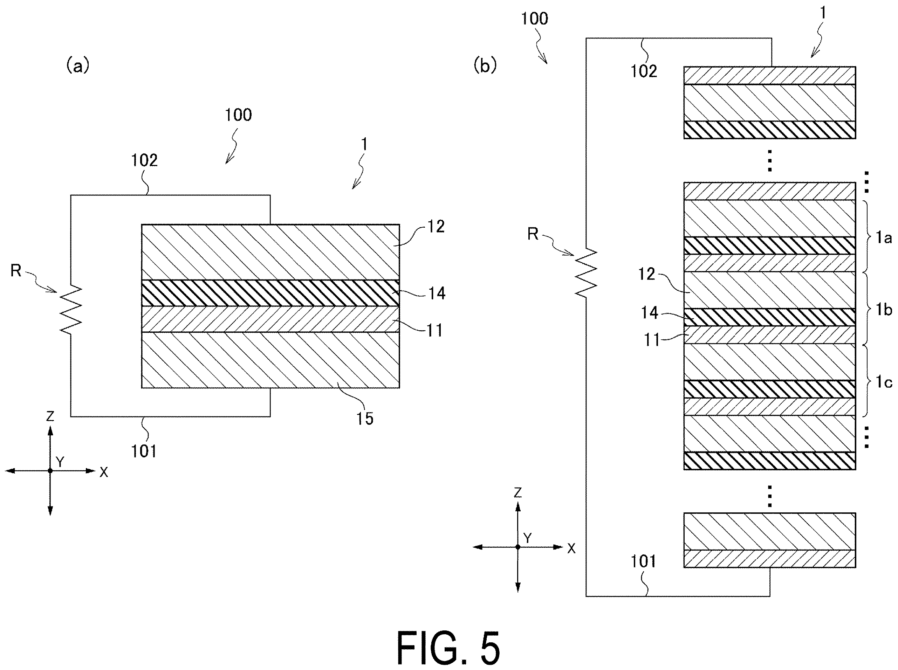

Note that the power generation element 1 may include only the first substrate 15 as illustrated in FIG. 5(a), for example, or may include only the second substrate 16. Additionally, for example, as illustrated in FIG. 5(b), the power generation element 1 may have a laminated structure of a plurality of structures (for example, 1a, 1b, 1c, and the like) each of which is obtained by laminating the first electrode 11, the intermediate portion 14, and the second electrode 12 in this order without including the substrates 15 and 16, or may have a laminated structure including at least one of the substrates 15 and 16.

### Operation Example of Power Generation Element 1

For example, when thermal energy is applied to the power generation element 1, an electric current is generated between the first electrode 11 and the second electrode 12, and the thermal energy is converted into electric energy. An amount of the electric current generated between the first electrode 11 and the second electrode 12 depends not only on the thermal energy but also on the difference between the work function of the second electrode 12 and the work function of the first electrode 11.

The amount of the generated electric current can be increased by, for example, increasing the difference between the work functions of the first electrode 11 and the second electrode 12 and decreasing the gap G. For example, an amount of the electric energy generated by the power generation element 1 can be increased by considering at least one of increasing the difference between the work functions and decreasing the gap G. In addition, providing the nanoparticles 141 between the electrodes 11 and 12 can increase the amount of electrons moving between the electrodes 11 and 12, which can lead to an increase in the amount of the electric current.

Note that the "work function" refers to the minimum energy required to extract, into a vacuum, electrons existing in a solid. The work function can be measured by using ultraviolet photoelectron spectroscopy (UPS), X-ray photoelectron spectroscopy (XPS), or Auger electron spectroscopy (AES), for example.

### Embodiment: Method for Manufacturing Power Generation Element 1

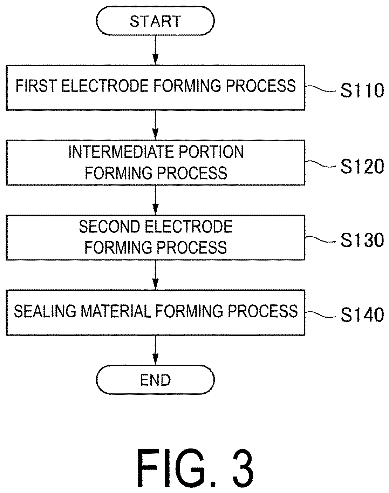

Next, an example of a method for manufacturing the power generation element 1 according to the present embodiment will be described. FIG. 3 is a flowchart illustrating the example of the method for manufacturing the power generation element 1 according to the present embodiment.

The method for manufacturing the power generation element 1 includes a first electrode forming process S 110, an intermediate portion forming process S120, and a second electrode forming process S130, and may include, for example, a sealing material forming process S140.

### First Electrode Forming Process S 110

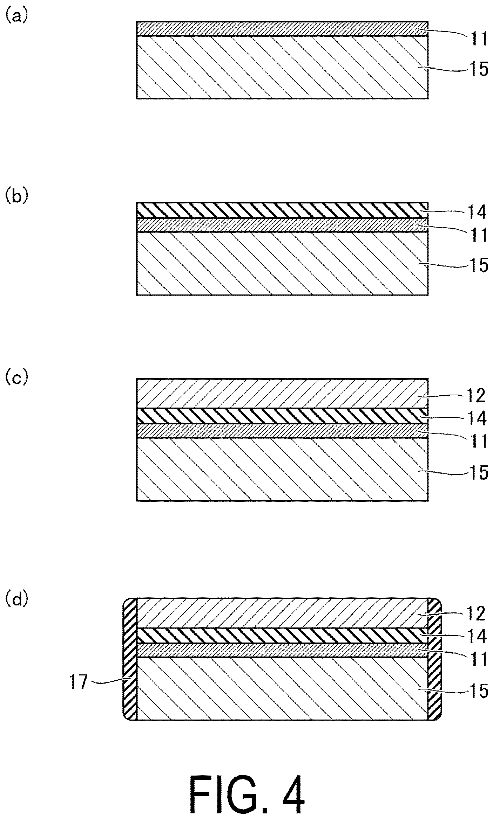

In the first electrode forming process S 110, the first electrode 11 is formed. In the first electrode forming process S110, for example, as illustrated in FIG. 4(a), the first electrode 11 is formed on the first substrate 15. The first electrode 11 is formed by, for example, a sputtering method or a vacuum deposition method under a reduced pressure environment, for example, or is formed by using a known electrode forming technique. Note that in the first electrode forming process S 110, for example, the first electrode 11 may be formed by processing an extended electrode material into a freely selected size instead of the first substrate 15. In this case, the first substrate 15 does not need to be used.

In the first electrode forming process S110, the first electrode 11 may be formed on the first substrate 15, for example. For example, when a film-like member is used as the first substrate 15, the first electrode 11 may be applied onto the first substrate 15, and the first substrate 15 and the first electrode 11 may be wound into a roll shape. Thereafter, for example, after or before at least one of the intermediate portion forming process S120, the second electrode forming process S130, and the sealing material forming process S140, which will be described later, the first substrate 15 and the first electrode 11 may be cut into an area corresponding to the application.

### Intermediate Portion Forming Process S120

In the intermediate portion forming process S120, for example, as illustrated in FIG. 4(b), the intermediate portion 14 including the insulating layer 142 being in a solid state is formed on the first electrode 11. In the intermediate portion forming process S120, for example, an insulating material including the nanoparticles 141 in a dispersed manner is applied to the surface of the first electrode 11, and the insulating material is cured to form the insulating layer 142. Thus, the intermediate portion 14 including the insulating layer 142 including the nanoparticles 141 in the dispersed manner and being a solid state is formed.

In the intermediate portion forming process S120, an insulating material is applied to the surface of the first electrode 11 by a known coating technique such as a screen printing method or a spin coating method. A film thickness of the insulating material to be applied can be freely selected and set in accordance with design of the gap G described above.

As the insulating material, a known polymer material having an insulating property such as an epoxy resin is used. As the insulating material, in addition to a thermosetting resin, for example, an ultraviolet curable resin is used. In the intermediate portion forming process S120, heating, UV irradiation, or the like may be performed on the applied insulating material depending on the characteristics of the insulating material to form the insulating layer 142.

In the intermediate portion forming process S120, for example, a nanoparticle material may be mixed into a freely selected inorganic material, and then, laser irradiation may be performed. Thus, the nanoparticles 141 dispersed in the insulating layer 142 are formed, and the intermediate portion 14 is formed.

### Second Electrode Forming Process S130

In the second electrode forming process S130, for example, as illustrated in FIG. 4(c), the second electrode 12 is formed on the insulating layer 142. The second electrode 12 is formed by using, for example, a material having a work function lower than that of the first electrode 11. The second electrode 12 is formed by using a known electrode forming technique such as a nanoimprinting method.

In the second electrode forming process S130, the second electrode 12 is formed on the surface of the insulating layer 142 by a sputtering method or a vacuum deposition method under a reduced pressure environment, for example. In this case, when the second electrode 12 is formed, a main surface of the second electrode 12 is in contact with the insulating layer 142 without being exposed to the atmosphere or the like. This can suppress a variation in the work function of the second electrode 12. This makes it possible to further stabilize the power generation amount.

In the second electrode forming process S130, the second electrode 12 may be formed by bringing the surface of the second electrode 12 provided on the second substrate 16 in advance into contact with the surface of the insulating layer 142, for example. In this case, as compared with the case where the second electrode 12 is directly formed on the surface of the insulating layer 142, a variation in a surface state of the second electrode 12 caused by a surface state of the insulating layer 142 can be suppressed. This makes it possible to increase the power generation amount.

For example, when a film-like member is used as the second substrate 16, the suppression of the variation can be achieved by preparing the second substrate 16 coated with the second electrode 12, and for example, the second substrate 16 and the second electrode 12 may be prepared in a wound state into a roll shape. Thereafter, for example, before or after the sealing material forming process S140, which will be described later, the second substrate 16 and the second electrode 12 may be cut into an area according to the application.

Note that in the second electrode forming process S130, for example, the intermediate portion 14 and the second electrode 12 may be heated after forming the second electrode 12 on the insulating layer 142. The heating of the intermediate portion 14 and the second electrode 12 may be performed instead of the heating in the intermediate portion forming process S120, for example, or may be performed in addition to the heating in the intermediate portion forming process S120. In this case, the surface of the insulating layer 142 being in contact with the second electrode 12 is easily flattened. This can suppress the occurrence of a slight gap between the insulating layer 142 and the second electrode 12. This makes it possible to increase the power generation amount.

### Sealing Material Forming Process S140

For example, the sealing material forming process S140 may be performed after the second electrode forming process S130. In the sealing material forming process S140, for example, as illustrated in FIG. 4(d), a sealing material 17 is formed so as to be in contact with the first electrode 11, the intermediate portion 14, and the second electrode 12. The sealing material 17 is formed by using a known technique such as a nanoimprinting method.

As the sealing material 17, an insulating material is used, and for example, a known insulating resin such as fluorine-based insulating resins is used. Forming the sealing material 17 can suppress deterioration of the insulating layer 142 and the nanoparticles 141 due to an external environment. This can improve durability.

In particular, when the sealing material 17 is formed so as to cover the intermediate portion 14, the intermediate portion 14 is not exposed to the outside, which can further improve the durability.

The power generation element 1 according to the present embodiment is formed by performing the above-described processes. For example, the second substrate 16 illustrated in FIG. 1(a) may be formed on the second electrode 12. In addition, the power generation device 100 according to the present embodiment is formed by forming the wiring lines 101 and 102, and the like, for example.

According to the present embodiment, in the intermediate portion forming process S120, the intermediate portion 14 including the insulating layer 142 being in a solid state is formed on the first electrode 11, and the intermediate portion 14 includes the nanoparticles 141 fixed in a dispersed state in the insulating layer 142. That is, movement of the nanoparticles 141 between the electrodes (the first electrode 11 and the second electrode 12) is suppressed. Thus, uneven distribution of the nanoparticles 141 on one electrode side over time and a decrease in movement amount of electrons can be suppressed. This makes it possible to stabilize the power generation amount.

Additionally, according to the present embodiment, in the intermediate portion forming process S120, the intermediate portion 14 including the insulating layer 142 being in a solid state is formed on the first electrode 11. Furthermore, the second electrode forming process S130 forms the second electrode 12 having a work function different from a work function of the first electrode 11 on the insulating layer 142. Thus, as compared with a case where a solvent or the like is used instead of the insulating layer 142, a support portion or the like for maintaining the distance (gap G) between the electrodes does not need to be provided, and the variation in the gap G caused by formation accuracy of the support portion can be eliminated. This makes it possible to increase the power generation amount.

Further, according to the present embodiment, the sealing material forming process S140 forms the sealing material 17 being in contact with the first electrode 11, the intermediate portion 14, and the second electrode 12 after the second electrode forming process S130. In this case, deterioration of the insulating layer 142 and the nanoparticles 141 caused by an external environment can be suppressed. This can improve durability.

Further, according to the present embodiment, the second electrode forming process S130 forms the second electrode 12 on the surface of the insulating layer 142 under a reduced pressure environment. This can suppress a variation in the work function of the second electrode 12. This makes it possible to further stabilize the power generation amount.

Further, according to the present embodiment, for example, the second electrode forming process S130 includes bringing the surface of the second electrode 12 provided on the second substrate 16 in advance into contact with the surface of the insulating layer 142. In this case, as compared with the case where the second electrode 12 is directly formed on the surface of the insulating layer 142, a variation in a surface state of the second electrode 12 caused by a surface state of the insulating layer 142 can be suppressed. This makes it possible to increase the power generation amount.

Further, according to the present embodiment, the insulating layer 142 includes an organic polymer compound. Thus, the insulating layer 142 can be flexibly formed. As a result, the power generation element 1 having a shape suitable for its application can be formed.

Further, according to the present embodiment, for example, the intermediate portion 14 is provided on the first electrode 11 and includes the insulating layer 142 being in the solid state and the nanoparticles 141 fixed in the dispersed state in the insulating layer 142. That is, movement of the nanoparticles 141 between the electrodes (the first electrode 11 and the second electrode 12) is suppressed. Thus, uneven distribution of the nanoparticles 141 on one electrode side over time and a decrease in movement amount of electrons can be suppressed. This makes it possible to stabilize the power generation amount.

Further, according to the present embodiment, for example, the intermediate portion 14 is provided on the first electrode 11 and includes the insulating layer 142 being in the solid state. Furthermore, the second electrode 12 is provided on the insulating layer 142 and has the work function different from the work function of the first electrode 11. Thus, as compared with a case where a solvent or the like is used instead of the insulating layer 142, a support portion or the like for maintaining the distance (gap G) between the electrodes does not need to be provided, and the variation in the gap G caused by formation accuracy of the support portion can be eliminated. This makes it possible to increase the power generation amount.

Further, according to the present embodiment, the nanoparticles 141 include a metal oxide other than magnetic substances. Thus, a decrease in power generation amount over time can be suppressed without being influenced by a magnetic field caused by an external environment.

### Embodiment: Electronic Apparatus 500

### Electronic Apparatus 500

The power generation element 1 and the power generation device 100 that have been described above can be mounted on, for example, an electronic apparatus. Some embodiments of the electronic apparatus will be described below.

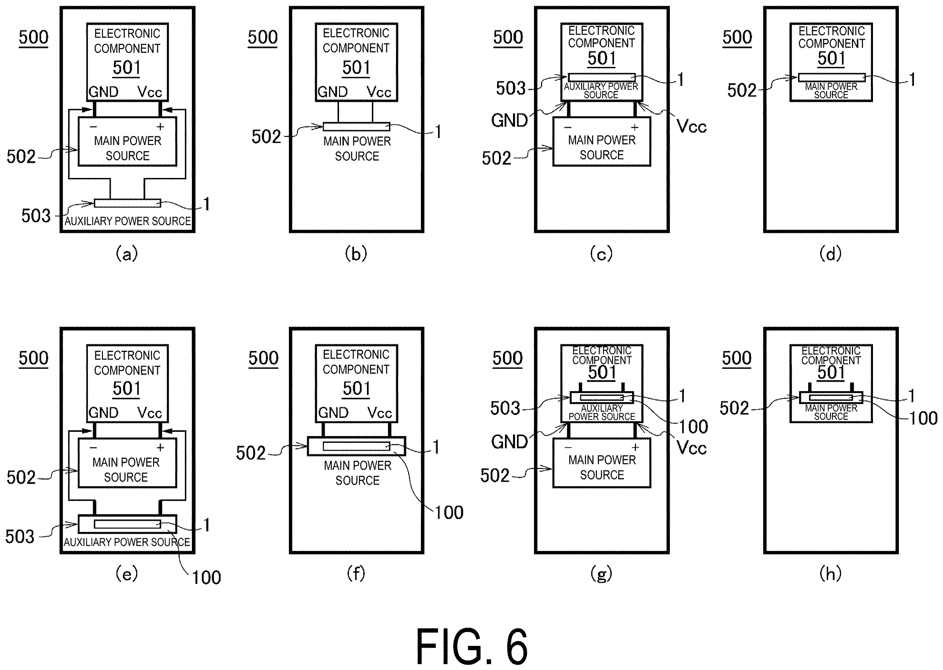

FIG. 6(a) to FIG. 6(d) are schematic block diagrams illustrating examples of an electronic apparatus 500 including the power generation element 1. FIG. 6(e) to FIG. 6(h) are schematic block diagrams illustrating examples of the electronic apparatus 500 including the power generation device 100 including the power generation element 1.

As illustrated in FIG. 6(a), the electronic apparatus 500 (electric product) includes an electronic component 501 (electronic component), a main power source 502, and an auxiliary power source 503. Each of the electronic apparatus 500 and the electronic component 501 is an electrical device.

The electronic component 501 is driven by using the main power source 502 as a power source. Examples of the electronic component 501 include a CPU, a motor, a sensor terminal, and a lighting device. When the electronic component 501 is, for example, the CPU, the electronic apparatus 500 includes an electronic device that can be controlled by a built-in master (CPU). When the electronic component 501 includes, for example, at least one of the motor, the sensor terminal, the lighting device, and the like, the electronic apparatus 500 includes an external master or an electronic apparatus that can be controlled by a person.

The main power source 502 is, for example, a battery. Examples of the battery also include rechargeable batteries. A positive terminal (+) of the main power source 502 is electrically connected to a Vcc terminal (Vcc) of the electronic component 501. A negative terminal (-) of the main power source 502 is electrically connected to a GND terminal (GND) of the electronic component 501.

An auxiliary power source 503 is the power generation element 1. The power generation element 1 includes at least one power generation element 1 described above. In the electronic apparatus 500, the auxiliary power source 503 is used together with the main power source 502, for example, and can be used as a power source for assisting the main power source 502 or as a power source for backing up the main power source 502 when a capacity of the main power source 502 is exhausted. When the main power source 502 is a rechargeable battery, the auxiliary power source 503 can also be used as a power source for charging the battery.

As illustrated in FIG. 6(b), the main power source 502 may be the power generation element 1. The electronic apparatus 500 illustrated in FIG. 6(b) includes the power generation element 1 to be used as the main power source 502 and the electronic component 501 capable of being driven by using the power generation element 1. The power generation element 1 is an independent power source (for example, an off-grid power source). Thus, the electronic apparatus 500 can be, for example, a stand-alone type. In addition, the power generation element 1 is an energy harvesting type. The electronic apparatus 500 illustrated in FIG. 6(b) does not need to replace the battery.

As illustrated in FIG. 6(c), the electronic component 501 may include the power generation element 1. An anode of the power generation element 1 is electrically connected to, for example, a GND wiring line of a circuit board (not illustrated). A cathode of the power generation element 1 is electrically connected to, for example, a Vcc wiring line of the circuit board (not illustrated). In this case, the power generation element 1 can be used as, for example, the auxiliary power source 503 of the electronic component 501.

As illustrated in FIG. 6(d), when the electronic component 501 includes the power generation element 1, the power generation element 1 can be used as, for example, the main power source 502 of the electronic component 501.

As illustrated in each of FIG. 6(e) to FIG. 6(h), the electronic apparatus 500 may include the power generation device 100. The power generation device 100 includes the power generation element 1 as a source of electric energy.

The embodiment illustrated in FIG. 6(d) includes the power generation element 1 in which the electronic component 501 is used as the main power source 502. Similarly, the embodiment illustrated in FIG. 6(h) includes the power generation device 100 in which the electronic component 501 is used as a main power source. In these embodiments, the electronic component 501 includes an independent power source. Thus, the electronic component 501 can be, for example, a self-standing type. The self-standing electronic component 501 can be effectively used in, for example, an electronic apparatus that includes a plurality of electronic components and in which at least one electronic component is separated from another electronic component. An example of such an electronic apparatus 500 is a sensor. The sensor includes a sensor terminal (slave) and a controller (master) separated from the sensor terminal. Each of the sensor terminal and the controller is the electronic component 501. When the sensor terminal includes the power generation element 1 or the power generation device 100, the sensor terminal is a self-standing type sensor terminal and does not need to be supplied with electric power by wiring. Since the power generation element 1 or the power generation device 100 is an energy harvesting type, the battery does not need to be replaced. The sensor terminal can also be regarded as one electronic apparatus 500. The sensor terminal regarded as the electronic apparatus 500 further includes, for example, an IoT wireless tag and the like in addition to the sensor terminal of the sensor.

What is common to the embodiments illustrated in FIG. 6(a) to FIG. 6(h) is that the electronic apparatus 500 includes the power generation element 1 that converts thermal energy into electric energy, and the electronic component 501 that can be driven by using the power generation element 1 as a power source.

The electronic apparatus 500 may be an autonomous type including an independent power source. Examples of the autonomous type of electronic apparatus include robots. Furthermore, the electronic component 501 including the power generation element 1 or the power generation device 100 may be an autonomous type including an independent power source. Examples of the autonomous type of electronic component include movable sensor terminals.

Although some embodiments have been described, these embodiments have been presented by way of examples only, and are not intended to limit the scope of the invention. Indeed, these novel embodiments described herein may be embodied in a variety of other forms, and furthermore, various omissions, substitutions and changes in the forms of the embodiments described herein may be made without departing from the spirit of the invention. These embodiments and modifications thereof are included in the scope and gist of the invention, and are included in the invention described in the claims and the scope equivalent thereto.

### Reference Signs List

1: Power generation element
11: First electrode
12: Second electrode
14: Intermediate portion
15: First substrate
16: Second substrate
17: Sealing material
100: Power generation device
101: First wiring line
102: Second wiring line
140: Space
141: Nanoparticle
141a: Coating
142: Insulating layer
500: Electronic apparatus
501: Electronic component
502: Main power source
503: Auxiliary power source
G: Gap
R: Load
S110: First electrode forming process
S120: Intermediate portion forming process
S130: Second electrode forming process
S140: Sealing material forming process
Z: First direction
X: Second direction
Y: Third direction

## Claims

1. A method for manufacturing a power generation element that does not require a temperature difference between electrodes in converting thermal energy into electric energy, the method comprising:
a first electrode forming process of forming a first electrode;
an intermediate portion forming process of forming, on the first electrode, an intermediate portion including an insulating layer being in a solid state; and
a second electrode forming process of forming a second electrode having a work function different from a work function of the first electrode, wherein
the intermediate portion includes nanoparticles fixed in a dispersed state in the insulating layer.

2. The method for manufacturing the power generation element according to claim 1, the method further comprising:
after the second electrode forming process, a sealing material forming process of forming a sealing material being in contact with the first electrode, the intermediate portion, and the second electrode.

3. The method for manufacturing the power generation element according to claim 1, wherein
the second electrode forming process forms the second electrode on a surface of the insulating layer under a reduced pressure environment, and
the work function of the first electrode is higher than the work function of the second electrode.

4. The method for manufacturing the power generation element according to claim 1, wherein
the second electrode forming process includes bringing a surface of the second electrode provided on a substrate in advance into contact with a surface of the insulating layer.

5. The method for manufacturing the power generation element according to claim 1, wherein
the insulating layer includes an organic polymer compound.

6. A power generation element that does not require a temperature difference between electrodes in converting thermal energy into electric energy, the power generation element comprising:
a first electrode;
an intermediate portion provided on the first electrode, the intermediate portion including an insulating layer being in a solid state; and
a second electrode provided on the insulating layer, the second electrode having a work function different from a work function of the first electrode, wherein
the intermediate portion includes nanoparticles fixed in a dispersed state in the insulating layer.

7. The power generation element according to claim 6, wherein
the nanoparticles include a metal oxide other than magnetic substances.

8. A power generation device comprising:
the power generation element according to claim 6;
a first wiring line electrically connected to the first electrode; and
a second wiring line electrically connected to the second electrode.

9. An electronic apparatus comprising:
the power generation element according to claim 6; and
an electronic component configured to be driven by using the power generation element as a power source.
